Europäisches Patentamt

European Patent Office

Office européen des brevets

(19)

(11) Publication number: **0 044 636**
**B1**

(12) **EUROPEAN PATENT SPECIFICATION**

(45) Date of publication of patent specification: **13.06.84**

(21) Application number: **81302981.6**

(22) Date of filing: **01.07.81**

(51) Int. Cl.³: **H 01 R 43/00,**
**H 05 K 13/06**

(54) Method of manufacturing an electrical interconnection assembly.

(30) Priority: **17.07.80 FR 8015821**

(43) Date of publication of application:
**27.01.82 Bulletin 82/4**

(45) Publication of the grant of the patent:
**13.06.84 Bulletin 84/24**

(84) Designated Contracting States:
**BE DE FR GB IT NL SE**

(56) References cited:
**DE - A - 2 758 472**
**US - A - 3 295 189**
**US - A - 3 377 698**

(73) Proprietor: **AMP INCORPORATED**
**P.O. Box 3608 449 Eisenhower Boulevard**
**Harrisburg Pennsylvania 17105 (US)**

(72) Inventor: **Dechelette, Helen**
**175 Bd. de la Republique**
**F-92210 St. Cloud (FR)**

(74) Representative: **Gray, Robin Oliver et al,**
**BARON & WARREN 18 South End Kensington**
**London W8 5BU (GB)**

Courier Press, Leamington Spa, England.

## Description

This invention relates to a method of manufacturing an electrical interconnection assembly comprising a plurality of electrical terminals carried by a common electrically insulating support and interconnected in a predetermined arrangement by electrical conductors. An example of one type of such assembly is disclosed in US—A—3 377 698.

Such assemblies find many uses in electrical devices and equipment, a particular of a certain type use being as a so-called central junction unit in the electrical wiring of an automobile, where the assembly would serve to interconnect various parts of the wiring harness of the automobile and would carry, for example, fuses and relays connected into the wiring harness.

Known such central junction units comprise one or more printed circuit boards constituting the electrically insulating support and electrical conductors of the assembly, the fuses and relays being mounted on appropriate terminals mounted on the board, and the parts of the wiring harness being connected to the conductors on the board by means of conventional printed circuit board edge connectors.

These known assemblies suffer from the disadvantages that they are relatively expensive in that they use conventional printed circuit boards and edge connectors, and are also relatively difficult and time-consuming to manufacture in requiring terminals to be soldered to the conductors on the printed circuit board, this adding further to the cost of the assembly.

According to this invention a method of manufacturing an electrical interconnection assembly as set out above is characterised by the steps of laying a continuous length of insulated electrical wire in a groove formed in a template; cutting the length of wire in the groove into a plurality of pieces; and urging the pieces of wire from the groove on to an insulating support carrying a plurality of electrical terminals each having a slotted plate portion providing an insulation displacement slot which receives a piece of wire and establishes an electrical connection thereto whereby the terminals become interconnected by the pieces of wire in the predetermined arrangement.

The method of this invention has the advantages that it is simple and quick, and thus cheap, to carry out, and avoids the use of conventional printed circuit boards and edge connectors therefor.

The template can be of metal, for example aluminium, and the groove can be cut therein using a computer controlled machine. The same computer programme can then be used to control an automatic machine serving to lay the wire in the groove, the wire laying head following the same route along the groove as was followed by the tool forming the groove.

Preferably the wire used has a solid core since this makes the wire relatively rigid and thus helps to retain the wire in the groove.

The length of wire can be cut into a plurality of pieces while in the groove by means of an appropriate array of cutting pins projecting from a carrier plate which is urged towards the grooved side of the template, the cutting pins engaging the wire and cutting it against the sides of holes formed in the bottom of the groove into which holes the cutting pins pass after having cut the wire.

The pieces of wire in the groove in the template after the cutting operation can be urged from the groove by means of an appropriate array of ejection pins carried by an ejection plate which is urged towards the face of the template remote from the groove, the ejection pins entering holes in the template communicating with the groove thereby to engage the pieces of wire and urge them out of the groove.

Preferably the array of ejection pins includes at least two associated with each terminal slotted plate portion, which two ejection pins engage a piece of wire on opposite sides of and adjacent the associated slotted plate portion thereby to serve as stuffers to urge the piece of wire into the slot in the associated slotted plate portion.

The electrical terminals can each have a slotted plate portion projecting from one face to the insulating support for receipt of a piece of wire, and an integrally formed contact portion projecting from an opposite face of the insulating support for mating with a terminal terminating a conductor or device to be connected to the assembly. Thus, the contact portion of a terminal can be a male tab for mating with a tab receptacle terminating a conductor, or a receptacle for receiving an end of a cartridge fuse, or a receptacle for receiving a tab on, for example, a flat blade fuse or a relay.

If more than one piece of wire is to be connected to a particular terminal then the slotted plate portion of that terminal can be provided with the appropriate number of slots, the groove in the template following the path necessary to direct the relevant pieces of wire for connection to these slots.

After manufacture the insulating support carrying the terminals with the pieces of wire connected thereto can be mounted in a box of insulating material suitable for mounting, for example, in an automobile, with the contact portions of the terminals accessible as necessary from outside the box.

Preferably the members making up the box are formed with inwardly directed webs which project between the slotted plate and/or contact portions of adjacent terminals to prevent unwanted short circuit connections between such terminals.

The method of this invention can be carried out on many different types of machine. For example the wire laying, cutting and push out steps can all be carried out at a single station with appropriate changes in the tool operative at the station, or otherwise the wire laying step can be carried out at one station with the insulating support with the wire in the groove therein then being moved to a second station for the cutting and push out steps to be carried out.

Further, the machine can be one which operates on a plurality of identical assemblies simultaneously whereby one computer programme can be used to control a plurality of wire laying heads.

This invention will now be described by way of example with reference to the diagrammatic drawings, in which:—

Figure 1 is a perspective view of a template with a groove therein;

Figure 2 is a perspective view of a carrier plate with cutting pins mounted thereon;

Figure 3 is a perspective view of an ejection plate with ejection pins mounted thereon;

Figure 4 is a sectional view showing a detail of the groove in the template of Figure 1;

Figure 5 is a sectional view showing a detail of the groove in the template of Figure 1 at the position of a cutting-pin-receiving hole;

Figure 6 is a sectional view showing a detail of the groove in the template of Figure 1 at the position of an ejection-pin-receiving hole;

Figure 7 is a perspective view of an insulating support carrying a plurality of electrical terminals; and

Figure 8 is a perspective view of an assembly manufactured by the method of the invention using the apparatus shown in Figures 1 to 7.

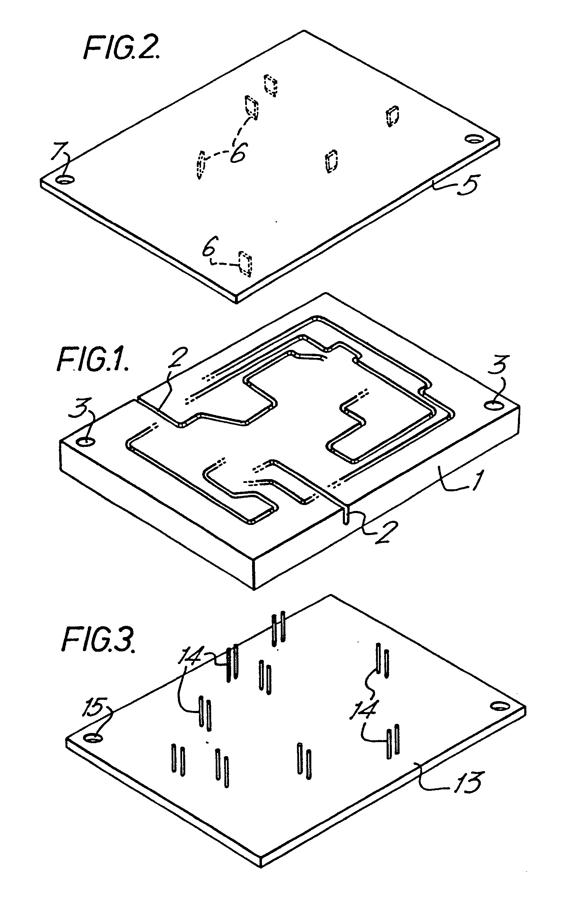

Figure 1 shows a template 1 in the form of a planar rectangular plate of aluminium having a groove 2 cut therein in accordance with a predetermined pattern. At two diagonally opposite corners the plate 1 is formed with through holes 3 by which the plate 1 can be accurately located on a machine bed. The groove 2 is cut in the plate 1 by means of a computer controlled machine.

Under the control of the programme used for cutting the groove 2 a machine then lays a continuous length of solid core insulated wire 4 (Figures 4, 5 and 6) in the groove 2.

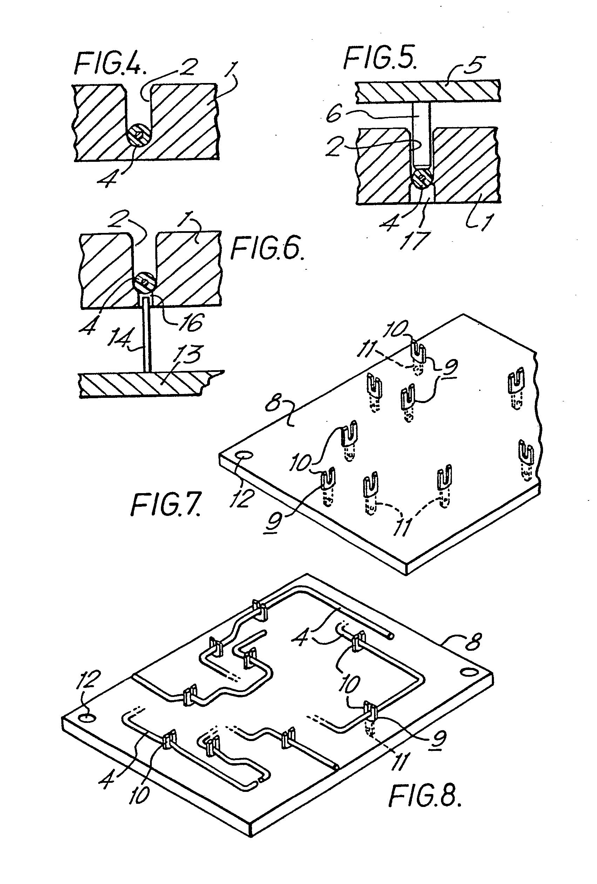

A carrier plate 5 (Figure 2) carrying a plurality of cutting pins 6 is then aligned with the template 1 by means of location holes 7 at two diagonally opposed corners thereof, with the cutting pins 6 directed towards the grooved face of the template 1. The template 1 and carrier plate 5 are then urged towards each other such that the cutting pins 6 engage the length of wire 4 over holes 17 (Figure 5) communicating with the groove 2 from the opposite face of the template 1 whereby the length of wire 4 is cut by the cutting pins 6 into a plurality of discrete pieces which remain in the groove 2.

Referring now to Figure 7, a planar insulating support 8 of plastics material has a plurality of electrical terminals 9 mounted thereon, each terminal 9 having a slotted plate portion 10 projecting from one face of the support 8, this portion 10 having a slot therein to receive and establish an electrical connection to an insulated wire, in known manner, and an integrally formed contact portion 11, such as a tab or a tab receptacle, projecting from the opposite face of the support 8. The terminals 9 are mounted on the support 8 in any convenient known manner.

The support 8 has location holes 12 at two diagonally opposite corners whereby the support 8 with the terminals 9 thereon can be accurately located over the grooved side of the template 1 with the slotted plate portions 10 directed towards the grooved side of the template 1.

Referring now to Figure 3 also, the template 1 with the pieces of wire in the groove 2 and with the insulating support 8 carrying the terminals 9 located as above described relative thereto, is positioned over an ejection plate 13 having a plurality of ejection pins 14 projecting therefrom. The ejection plate 13 has location holes 15 at two diagonally opposite corners to ensure accurate alignment with the template 1. The ejection plate 13 is then urged relatively towards the template 1 and the ejection pins 14 enter holes 16 (Figure 6) in the template 1, which holes 16 lead into the groove 2 whereby the ejection pins 14 engage the pieces of wire 4 in the groove 2 and urge them out of the groove 2 and on to the slotted plate portions 10 of the terminals 9 carried by the support 8. The ejection pins 14 are located to ensure reliable ejection of the pieces of wire 4 from the groove 2, and in particular two ejection pins 14 are located to engage on opposite sides of and adjacent each terminal slotted plate portion 10 whereby these ejection pins 14 act, in known manner, as stuffers serving to stuff the piece of wire 4 into the slot in the slotted plate portion 10 as required.

The above described method produces an electrical interconnection assembly as shown in Figure 8, comprising the insulating support 8 carrying the terminals 9 interconnected in a predetermined arrangement by the pieces of wire 4 engaged in the slots in their slotted plate portions 10 and with their contact portions 11 projecting from the opposite face of the support 8.

The insulating support 8 can be in the form of an insulating box with the contact portions 11 of the terminals accessible for connection to electrical leads and/or components, such a complete assembly being usable in an automobile to interconnect various parts of the wiring harness of the automobile and to connect components such as fuses and relays into the wiring harness.

If required the insulating support 8 can be formed as a plurality of pieces interconnected by integrally formed relatively thin web portions which will serve as hinges, whereby after manufacture as described above as a planar assembly the insulating support 8 can be folded about these hinges such that the pieces of the insulating support 8 lie in different planes, for example at right-angles relative to each other, to facilitate connection of leads and components to the contact portions 11 of the terminals 9 carried by the support 8. For example, for use in an automobile the support 8 can be formed in three pieces arranged in a row such that after folding the assembly and installation thereof in an automobile one end piece of the support 8 is directed towards the engine compartment, the other end piece is oppositely directed towards the passenger compartment, while the intermediate piece is upwardly directed to facilitate the mounting of components such as fuses and relays thereon.

**Claims**

1. A method of manufacturing an electrical interconnection assembly comprising a plurality of electrical terminals (9) carried by a common electrically insulating support (8) and interconnected in a predetermined arrangement by electrical conductors (4), the method being characterised by the steps of laying a continuous length of insulated electrical wire (4) in a groove (2) formed in a template (1); cutting the length of wire (4) in the groove (2) into a plurality of pieces; and urging the pieces of wire (4) from the groove (2) on to an insulating support (8) carrying a plurality of electrical terminals (9) each having a slotted plate portion (10) providing an insulation displacement slot which receives a piece of wire (4) and establishes an electrical connection thereto whereby the terminals (9) become interconnected by the pieces of wire (4) in the predetermined arrangement.

2. A method as claimed in Claim 1, characterised in that the wire (4) has a solid core.

3. A method as claimed in Claim 1 or Claim 2, characterised in that the length of wire (4) is cut into a plurality of pieces while in the groove (2) by means of an appropriate array of cutting pins (6) projecting from a carrier plate (5) which is urged towards the grooved side of the template (1), the cutting pins (6) engaging the wire (4) and cutting it against the sides of holes (17) formed in the bottom of the groove (2) into which holes (17) the cutting pins (6) pass after having cut the wire (4).

4. A method as claimed in any preceding claim, characterised in that the pieces of wire (4) in the groove (2) in the template (1) after the cutting operation are urged from the groove (2) by means of an appropriate array of ejection pins (14) carried by an ejection plate (13) which is urged towards the face of the template (1) remote from the groove (2), the ejection pins (14) entering holes (16) in the template (1) communicating with the groove (2) thereby to engage the pieces of wire (4) and urge them out of the groove (2).

5. A method as claimed in Claim 4, characterised in that the array of ejection pins (14) includes at least two associated with each terminal slotted plate portion (10), which two ejection pins (14) engage a piece of wire (4) on opposite sides of an adjacent the associated slotted plate portion (10) thereby to serve as stuffers to urge the piece of wire (4) into the slot in the associated slotted plate portion (10).

6. A method as claimed in any preceding claim, characterised in that the electrical terminals (9) each have a slotted plate portion (10) projecting from one face of the insulating support (8) for receipt of a piece of wire (4), and an integrally formed contact portion (11) projecting from an opposite face of the insulating support (8) for mating with a terminal terminating a conductor or device to be connected to the assembly.

7. A method as claimed in any preceding claim, characterised in that the slotted plate portion (10) of at least one terminal (9) is provided with a plurality of slots, the groove (2) in the template (1) following the path necessary to direct the wire (4) for connection in each of these slots.

8. A method as claimed in Claim 6, or Claim 7 as dependent upon Claim 6, characterised by the step of mounting the insulating support (8) carrying the terminals (9) with the pieces of wire (4) connected thereto in a box of insulating material with the contact portions (11) of the terminals accessible from outside the box.

9. A method as claimed in any preceding claim, characterised in that the insulating support (8) is formed as a plurality of pieces interconnected by integrally formed relatively thin web portions which will serve as hinges whereby after manufacture of an assembly as a planar assembly the insulating support (8) can be folded about those hinges such that the pieces of the insulating support (8) lie in different planes.

**Patentansprüche**

1. Verfahren zur Herstellung einer elektrischen Verbindungsanordnung mit einer Mehrzahl elektrischer Anschlüsse (9), die von einem gemeinsamen, elektrisch isolierenden Träger (8) getragen und in einer vorbestimmten Anordnung mittels elektrischer Leiter (4) gegenseitig verbunden werden, gekennzeichnet durch folgende Schritte: Einlagen einer kontinuierlichen Länge von isoliertem elektrischen Draht (4) in eine in einer Schablone (1) ausgebildete Nut (2); Zerschneiden der Länge des Drahtes (4) in der Nut (2) in eine Mehrzahl von Stücken; und Drängen der Drahtstücke (4) von der Nut (2) auf einen Isolierträger (8), der eine Mehrzahl elektrischer Anschlüsse (9) trägt, von denen jeder einen geschlitzten Plattenbereich (10) aufweist, der einen die Isolierung verdrängenden Schlitz schafft, der ein Drahtstück (4) aufnimmt und eine elektrische Verbindung mit diesem herstellt, wodurch die Anschlüsse (9) durch die Drahtstücke (4) in der vorbestimmten Anordnung gegenseitig verbunden werden.

2. Verfahren nach Anspruch 1, dadurch gekennzeichnet daß der Draht (4) einen Voll-Kern aufweist.

3. Verfahren nach Anspruch 1 oder 2, dadurch gekennzeichnet, daß die Drahtlänge (4), während sich diese in der Nut (2) befindet, in eine Mehrzahl von Stücken zerschnitten wird, und zwar mittels einer geeigneten Anordnung von Schneidstiften (6), die von einer Trägerplatte (5) wegstehen, die in Richtung auf die genutete Seite der Schablone (1) gedrängt wird, wobei die Schneidstifte (6) an dem Draht (4) angreifen und diesen gegen die Seiten von im Boden der Nut (2) ausgebildeten Löchern (17) schneiden, in die sich die Schneidstifte (6) nach dem Zerschneiden des Drahts (4) hineinerstrecken.

4. Verfahren nach einem der vorausgehenden Ansprüche, dadurch gekennzeichnet, daß die Drahtstücke (4) in der Nut (2) in der Schablone (1) nach dem Zerschneidvorgang aus der Nut (2) gedrängt werden, und zwar mittels einer geeigneten Anordnung von Auswurfstiften (14), die von einer Auswurfplatte (13) getragen werden, die in Richtung auf die von der Nut (2) abgelegene Seite der Schablone (1) gedrängt wird, wobei die Auswurfstifte (14) in mit der Nut (2) in Verbindung stehende Löcher (16) in der Schablone (1) eintreten, derart, daß sie an den Drahtstücken (4) angreifen und diese aus der Nut (2) herausdrängen.

5. Verfahren nach Anspruch 4, dadurch gekennzeichnet, daß von der Anordnung von Auswurfstiften (14) dem geschlitzten Plattenbereich (10) eines jeden Anschlusses (9) wenigstens zwei Auswurfstifte zugeordnet sind, die an gegenüberliegenden Seiten und in der Nähe des zugehörigen geschlitzten Plattenbereichs (10) an einem Drahtstück (4) angreifen, so daß sie als Stopfelemente zum Hineindrängen des Drahtstücks (4) in den Schlitz in dem zugehörigen geschlitzten Plattenbereich (10) dienen.

6. Verfahren nach einem der vorausgehenden Ansprüche, dadurch gekennzeichnet, daß die elektrischen Anschlüsse (9) jeweils einen von einer Seite des Isolierträgers (8) wegstehenden geschlitzten Plattenbereich (10) für die Aufnahme eines Drahtstücks (4) sowie einen einstückig damit ausgebildeten, von einer gegenüberliegenden Seite des Isolierträgers (8) wegstehenden Kontaktbereich (11) für die Verbindung mit einem einen Leiter abschließenden Anschluß oder mit einer mit der Anordnung zu verbindenen Vorrichtung aufweisen.

7. Verfahren nach einem der vorausgehenden Ansprüche, dadurch gekennzeichnet, daß der geschlitzte Plattenbereich (10) wenigstens eines Anschlusses (9) mit einer Mehrzahl von Schlitzen versehen ist, wobei die Nut (2) in der Schablone (1) der Bahn folgt, die zum Führen des Drahts (4) für das Anschließen in jedem dieser Schlitze erforderlich ist.

8. Verfahren nach Anspruch 6 oder Anspruch 7 bei dessen Abhängigkeit von Anspruch 6, gekennzeichnet durch den Schritt des Befestigens des die Anschlüsse (9) mit den damit verbundenen Drahtstücken (4) tragenden Isolierträgers (8) in einem Kasten aus isolierenden Material, wobei ein Zugang zu den Kontaktbereichen (11) der Anschlüsse von außerhalb des Kastens her möglich ist.

9. Verfahren nach einem der vorausgehenden Ansprüche, dadurch gekennzeichnet, daß der Isolierträger (8) in Form von mehreren Stücken ausgebildet ist, die durch einstückig ausgebildete, relativ dünne Stegbereiche miteinander verbunden sind, die als Scharniere dienen, wodurch nach dem Herstellen einer Anordnung in Form einer planaren Anordnung der Isolierträger (8) um diese Scharniere gefaltet werden kann, so daß die Teile des Isolierträgers (8) in verschiedenen Ebenen liegen.

**Revendications**

1. Procédé de fabrication d'un assemblage d'interconnexion électrique comprenant plusieurs bornes électriques (9) portées par un support commum électriquement isolant (8) et interconnectées suivant un agencement prédéterminé par des conducteurs électriques (4), le procédé étant caractérisé par les étapes qui consistent à poser une longueur continue de fils électriques isolés (4) dans une gorge (2) formée dans un gabarit (1); à couper la longueur de fil (4) dans la gorge (2) en plusieurs tronçons; et à repousser les tronçons de fil (4) de la gorge (2) sur un support isolant (8) portant plusieurs bornes électriques (9) ayant chacune une plaque encochée (10) présentant une encoche de déplacement d'isolant qui reçoit un tronçon de fil (4) et établit une connexion électrique avec lui afin que les bornes (9) deviennent interconnectées par les tronçons de fil (4) suivant l'agencement prédéterminé.

2. Procédé selon la revendication 1, caractérisé en ce que le fil (4) possède une âme pleine.

3. Procédé selon la revendication 1 ou la revendication 2, caractérisé en ce que la longueur du fil (4) est coupée en plusieurs tronçons, tandis que le fil se trouve dans la gorge (2), au moyen d'un réseau approprié de poinçons (6) de coupe dépassant d'une plaque (5) de support qui est déplacée vers la face à gorge du gabarit (1), les poinçons (6) de coupe portant contre le fil (4) et le coupant contre les bords de trous (17) formés dans le fond de la gorge (2), trous (17) dans lesquels les poinçons (6) de coupe passent après avoir coupé le fil (4).

4. Procédé selon l'une quelconque des revendications précédentes, caractérisé en ce que les tronçons de fil (4) se trouvant dans la gorge (2) du gabarit (1), après l'opération de coupe, sont repoussés de la gorge (2) au moyen d'un réseau approprié de tiges (14) d'éjection portées par une plaque (13) d'éjection qui est déplacée vers la face du gabarit (1) éloignée de la gorge (2), les tiges (14) d'éjection pénétrant dans les trous (16) du gabarit (1) communiquant avec la gorge (2) afin de porter contre les tronçons de fil (4) et de les repousser de la gorge (2).

5. Procédé selon la revendication 4, caractérisé en ce que le réseau de tiges (14) d'éjection comprend au moins deux tiges associées à chaque plaque encochée (10) de borne, lesquelles deux tiges (14) d'éjection portent contre un tronçon de fil (4) sur les côtés opposés et à proximité immédiate de la plaque encochée associée (10) afin de servir de poussoirs destinés à introduire le tronçon de fil (4) dans l'encoche de la plaque encochée associée (10).

6. Procédé selon l'une quelconque des revendications précédentes, caractérisé en ce que les bornes électriques (9) présentent chacune une plaque encochée (10) dépassant d'une face du support isolant (8) afin de recevoir un tronçon de fil (4), et un contact (11) réalisé d'une seule pièce avec chaque borne dépassant d'une face opposée du support isolant (8) pour s'accoupler avec une borne terminant un conducteur ou un dispositif à connecter à l'assemblage.

7. Procédé selon l'une quelconque des revendications précédentes, caractérisé en ce que la plaque encochée (10) d'au moins une borne (9) présente plusieurs encoches, la gorge (2) du gabarit (1) suivant le trajet nécessaire pour diriger le fil (4) afin de le connecter dans chacune de ces encoches.

8. Procédé selon la revendication 6 ou la revendication 7 dépendant de la revendication 6, caractérisé par l'étape qui consiste à monter le support isolant (8), portant les bornes (9) auxquelles les tronçons de fil (4) sont connectés, dans un boîtier en matière isolante, les contacts (11) étant accessibles de l'extérieur du boîtier.

9. Procédé selon l'une quelconque des revendications précédentes, caractérisé en ce que le support isolant (8) est formé de plusieurs pièces reliées entre elles par des voiles relativement minces, réalisés d'un seul bloc avec les pièces et servant de charnières de manière que, après la fabrication d'un assemblage sous la forme d'un assemblage plan, le support isolant (8) puisse être plié autour de ces charnières afin que les pièces du support isolant (8) s'étendent dans des plans différents.

FIG.2.

7     6     6     5

FIG.1.

2     3     3     1     2

FIG.3.

14     15     14     13

FIG.4.

FIG.5.

FIG.6.

FIG.7.

FIG.8.